# DEMANDE DE BREVET EUROPEEN

(11) **EP 1 385 198 A1**
(43) Date de publication de la demande: **28.01.2004**
(21) Numéro de dépôt: 03354067.5
(22) Date de dépôt: 23.07.2003
(51) Int. Cl.: H01L 21/60

(54) **Procédé de formation d'ouvertures de contact sur un circuit intégré MOS**

(30) Priorité: 23.07.2002 FR 0209347
(71) Demandeur: STMicroelectronics S.A., 92120 Montrouge (FR)
(72) Inventeur: Ferreira, Paul, 38530 Barraux (FR); Coronel, Philippe, 38530 Barraux (FR)
(74) Mandataire: de Beaumont, Michel

(57) **Abrégé**

L'invention concerne un procédé de formation d'ouvertures de contact en divers emplacements de la surface supérieure d'un circuit intégré comprenant des zones surélevées, des ouvertures critiques (42) devant être formées entre deux zones surélevées voisines, comprenant les étapes consistant à recouvrir la structure d'une première couche de protection (20) ; former des ouvertures non critiques (41) dans la première couche de protection ; revêtir la structure d'une seconde couche de protection (30) ; procéder à une irradiation oblique de sorte que la seconde couche de protection n'est pas irradiée au fond des régions situées entre deux zones surélevées ; éliminer les parties non irradiées de la seconde couche de protection ; éliminer les parties de la première couche de protection situées sous la seconde couche de protection aux emplacements où cette seconde couche de protection a été éliminée ; et éliminer les parties irradiées de la seconde couche de protection.

## Description

La présente invention concerne un procédé de formation d'ouvertures de contact vers des emplacements choisis de la surface d'un circuit intégré MOS.

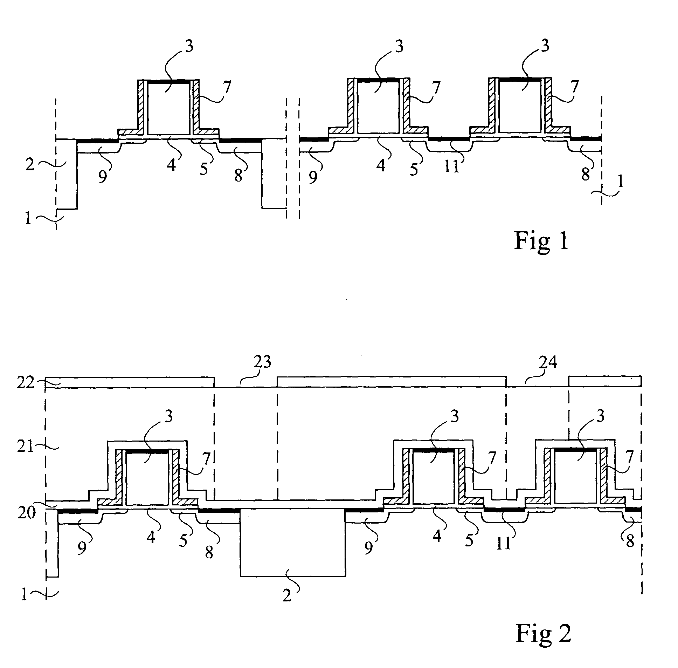

Pour les circuits intégrés MOS dans lesquels les structures élémentaires sont de très petites dimensions, par exemple dans lesquels les structures de grille ont une longueur inférieure au dixième de micromètre, une des limitations à la miniaturisation réside dans la formation d'ouvertures de contact vers des zones semiconductrices de la structure. Ceci va être illustré en relation avec la figure 1.

Dans la partie gauche de la figure 1, on a représenté un exemple de transistor MOS formé dans une zone active d'un substrat 1 délimitée par des tranchées peu profondes 2 remplies d'isolant (STI). Ce transistor MOS comprend une grille isolée 3 formée sur une mince couche d'isolant de grille 4. La grille 3 est couramment en silicium polycristallin et l'isolant de grille 4 en oxyde de silicium bien qu'actuellement on tende à préférer d'autres isolants à plus faible constante diélectrique. Cette grille sert à délimiter une première zone implantée 5 dans la zone active du substrat 1. Ensuite, la grille est entourée d'espaceurs, par exemple, comme cela est représenté, des espaceurs en nitrure de silicium 7 ayant en coupe une forme de L et séparés de la grille et du substrat par une très mince couche d'oxyde. Ces espaceurs servent à délimiter des régions plus fortement dopées de source et de drain 8 et 9 dans le substrat 1. De préférence, la surface supérieure de la grille 3 et les surfaces supérieures des régions de source et de drain 8 et 9 sont constituées d'une couche d'un siliciure métallique pour améliorer la conduction et favoriser l'établissement des contacts. Ces zones de siliciure métallique sont indiquées en figure 1 et dans les figures suivantes par un trait épais non référencé.

Dans la partie droite de la figure 1, on a représenté deux transistors analogues à celui de la partie gauche disposés côte à côte sans être séparés par une zone d'isolement. Ces deux transistors adjacents ont une région de drain/source commune 11 sur laquelle on peut souhaiter réaliser un contact.

On considérera par exemple, une structure dans laquelle les longueurs de grille sont de 0,65 nanomètre, les longueurs des zones faiblement dopées 5 sous les espaceurs 7 sont de l'ordre de 60 nm et les zones plus fortement dopées recouvertes d'oxyde 8, 9, 11 ont une largeur de l'ordre de 30 à 60 nm, la hauteur de la grille 3 au-dessus de la surface de substrat étant par exemple de 150 nm.

Un procédé classique de formation d'ouverture de contact est illustré en figure 2. L'ensemble de la structure illustrée en figure 1 est recouvert d'une couche de protection 20, par exemple une couche de nitrure de silicium. On dépose ensuite une couche isolante 21, regravée par gravure physico-chimique pour que sa surface supérieure soit plane. La couche 21 est recouverte d'un masque 22. On notera que cette couche isolante reste en place en fin de processus et doit être de bonne qualité. Elle résulte par exemple d'un dépôt par plasma à haute densité.

On suppose que l'on veut établir un premier contact avec une région de drain/source 8 proche d'une région d'isolement 2 et un second contact avec une région de drain/source 11 disposée entre deux transistors adjacents. Pour cela, on réalise des ouvertures 23 et 24 dans le masque 22 au-dessus des régions que l'on veut atteindre et l'on grave la couche isolante 21 puis la couche de protection 20 pour dégager les zones de contact. Le rôle de la couche de protection 20 est bien connu par ailleurs. Cette couche de protection sert d'arrêt de gravure de la couche 21 pour notamment éviter de sur-graver l'isolement constituant les régions d'isolement 2 entre transistors et de créer des zones de défaut aux limites de cet isolant.

L'ouverture du premier contact vers la région de drain/source 8 ne pose pas de problème critique étant donné que l'on peut déborder sans inconvénient au-dessus de la couche d'isolement 2.

Par contre, l'ouverture du second contact vers la région de drain/source 11 intermédiaire entre deux transistors adjacents pose des problèmes critiques étant donné les dimensions en cause. En effet, la précision de positionnement du masque 22 par rapport aux couches préalablement formées est de l'ordre de 80 nm. Cette différence est inférieure, dans le cadre de l'exemple décrit ci-dessus, à la distance entre la région 11 et les sommets des grilles 3 adjacentes. Ainsi, en cas de décalage excessif de l'ouverture 24 du masque, on sera amené à graver en même temps le nitrure de silicium au-dessus de la région 11 et au-dessus de l'une des grilles 3 adjacentes d'où il résulte un risque de court-circuit après métallisation. Ceci oblige à augmenter les dimensions du transistor uniquement pour résoudre ce problème de précision de réalisation des ouvertures de contact.

Bien que l'on ait décrit ci-dessus seulement deux types d'ouvertures de contact, on notera que d'autres types d'ouvertures seront généralement prévus, par exemple des ouvertures permettant de prendre directement des contacts sur les couches supérieures siliciurées des grilles 3. Ces ouvertures ne posent généralement pas de problème très critique, contrairement à l'établissement de contacts vers des régions intermédiaires entre des grilles voisines.

La présente invention vise à résoudre le problème de précision de réalisation des ouvertures de contact vers une région de drain/source intermédiaire entre deux transistors adjacents.

De plus, la présente invention vise à résoudre ce problème en utilisant des technologies déjà couramment utilisées pour la réalisation des ouvertures de contact.

Pour atteindre cet objet, la présente invention prévoit un procédé de formation d'ouvertures de contact en divers emplacements de la surface supérieure d'un circuit intégré comprenant des zones surélevées, certaines ouvertures dites ouvertures critiques devant être formées entre deux zones surélevées voisines, comprenant les étapes suivantes :
recouvrir l'ensemble de la structure d'une première couche de protection ;
former des ouvertures non critiques dans la première couche de protection ;
revêtir l'ensemble de la structure d'une seconde couche de protection présentant la caractéristique de résister spécifiquement à une gravure dans les zones où elle n'a pas reçu d'irradiation ;
procéder à une irradiation oblique de sorte que la seconde couche de protection n'est pas irradiée au fond des régions situées entre deux zones surélevées ;
éliminer les parties non irradiées de la seconde couche de protection ;
éliminer les parties de la première couche de protection situées sous la seconde couche de protection aux emplacements où cette seconde couche de protection a été éliminée ; et
éliminer les parties irradiées de la seconde couche de protection.

Selon un mode de réalisation de la présente invention, la première couche de protection est une couche de nitrure de silicium.

Selon un mode de réalisation de la présente invention, la seconde couche de protection est une couche de silicium polycristallin.

Selon un mode de réalisation de la présente invention, l'irradiation est une implantation de bore.

Selon un mode de réalisation de la présente invention, l'implantation oblique est réalisée sous un angle de 45 à 60°.

Selon un mode de réalisation de la présente invention, les zones surélevées correspondent à des zones de grille de transistors MOS.

Selon un mode de réalisation de la présente invention, les zones susceptibles d'être contactées sont revêtues d'un siliciure métallique.

Selon un mode de réalisation de la présente invention, l'étape de formation d'ouvertures non critiques dans la première couche de protection comprend les étapes consistant à revêtir la structure d'une couche planarisée, éliminer la couche planarisée aux emplacements desdites ouvertures non critiques, graver lesdites ouvertures dans la première couche de protection, et éliminer la couche planarisée.

Selon un mode de réalisation de la présente invention, la couche planarisée est une couche de résine.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 illustre des structures de transistors MOS selon l'art antérieur ;
la figure 2 illustre un procédé d'ouverture de contact selon l'art antérieur ;
les figures 3 à 6 illustrent des étapes successives d'un procédé d'ouverture de contact selon la présente invention ; et
les figures 7A à 7C sont des vues partielles illustrant des étapes intermédiaires entre les étapes des figures 5 et 6.

De façon générale, la présente invention prévoit un procédé de formation d'ouvertures de contact dans lequel des ouvertures non critiques sont formées de la même façon que cela a été décrit précédemment en relation avec l'art antérieur et dans lequel des ouvertures critiques entre deux régions de grille rapprochées sont formées par un procédé particulier compatible avec le procédé général d'ouverture des contacts et ne nuisant pas aux ouvertures déjà formées par le procédé classique.

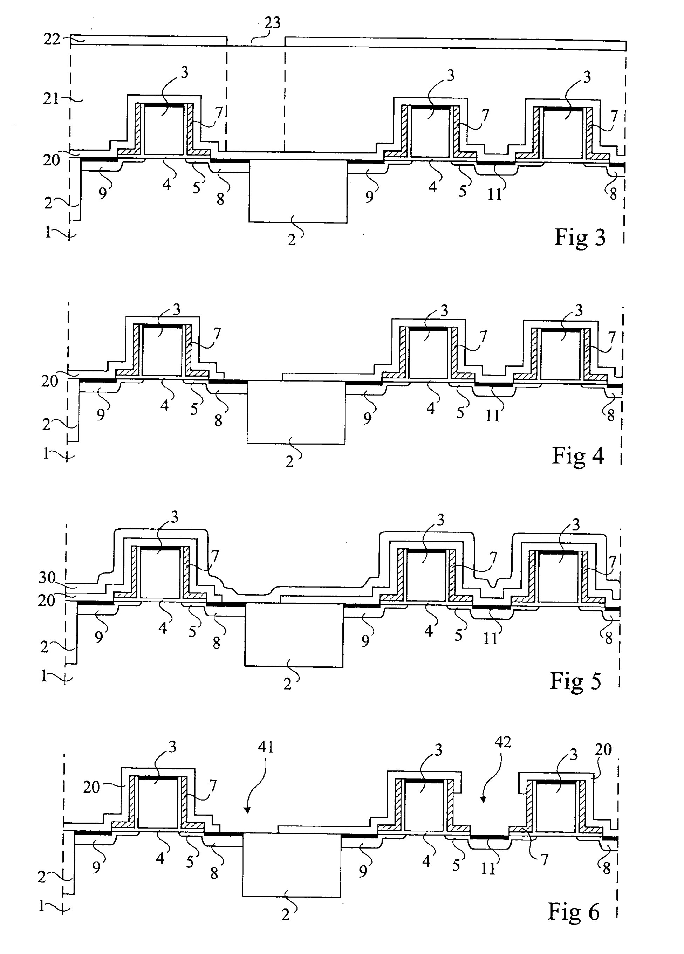

Plus particulièrement, la figure 3 représente la structure selon la présente invention au même stade que cela a été décrit en relation avec la figure 2, c'est-à-dire après dépôt d'une couche de protection 20, d'une couche isolante planarisée 21 et d'une couche de masquage 22. Toutefois, comme on le notera ci-après, la couche 21 est ensuite éliminée dans le procédé selon l'invention et ne doit pas nécessairement présenter d'excellentes qualités diélectriques. Cette couche 21 peut donc être par exemple une simple couche de résine, ce qui simplifie la fabrication.

Toutes les ouvertures non critiques sont formées dans une première étape en réalisant des ouvertures 23 dans le masque 22 comme cela a été décrit en relation avec la figure 2 au-dessus des zones non critiques. Les ouvertures 23 servent à délimiter une gravure anisotrope de la couche isolante 21. Cette gravure s'arrête quand la couche de protection 20, par exemple une couche de nitrure de silicium d'une épaisseur de 30 nm est atteinte. Ensuite, la couche 20 est gravée pour former des ouvertures au-dessus des emplacements non critiques définis précédemment.

Après cette étape, comme l'illustre la figure 4, on élimine le masque 22 et la couche isolante planarisée 21.

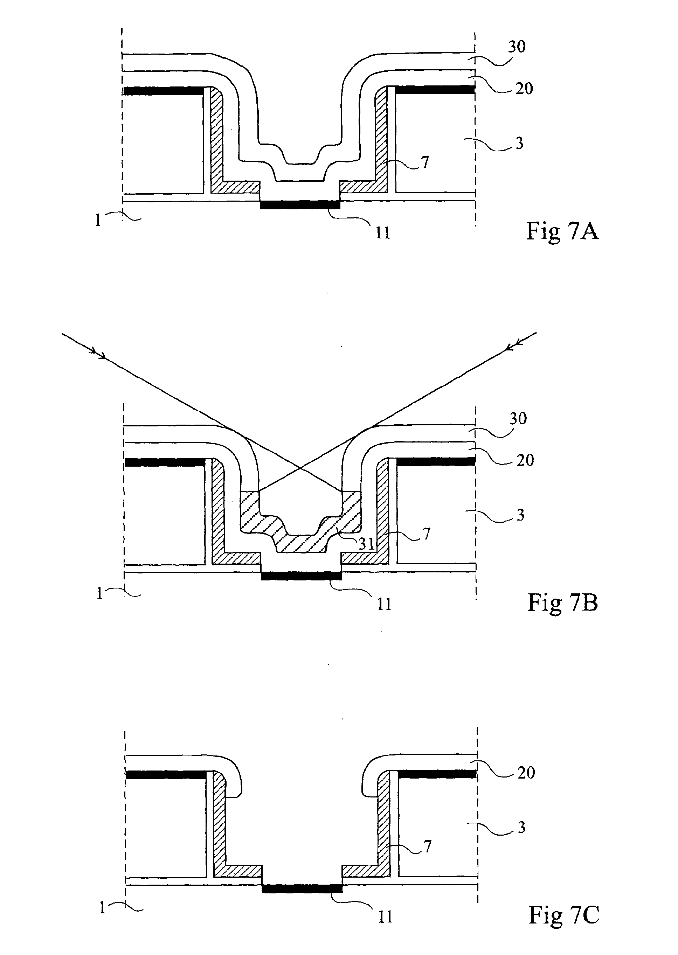

Lors d'une étape suivante, comme l'illustre la figure 5, on dépose sur l'ensemble de la structure une deuxième couche de protection 30, par exemple en silicium polycristallin ayant par exemple une épaisseur de l'ordre de 20 nm par un procédé de dépôt à basse température. Ensuite, pour arriver à la structure illustrée en figure 6, on procède aux étapes décrites en relation avec les figures 7A à 7C.

La figure 7A représente un agrandissement de la partie disposée entre deux zones de grille et correspond à ce qui a été représenté dans la partie droite de la figure 1. La structure est recouverte d'une part de la couche de nitrure de silicium 20, d'autre part de la couche de silicium polycristallin 30.

A l'étape suivante, illustrée en figure 7B, on procède à une implantation oblique à faible dose et faible énergie, par exemple de bore sous 1 keV selon un angle de préférence compris entre 45 et 60 degrés tandis que la plaquette est montée sur un support tournant. Il en résulte que la partie profonde 31 de la couche de silicium polycristallin 30, située sous la zone d'irradiation et hachurée en figure 7B, n'est pas irradiée. Le silicium polycristallin présente la propriété selon laquelle les zones non irradiées peuvent être gravées sélectivement par rapport aux zones irradiées.

Aux étapes suivantes, illustrées en figure 7C, on procède successivement à l'élimination de la partie profonde 31 de silicium polycristallin, puis, en utilisant la couche restante de silicium polycristallin comme masque de gravure, à l'élimination de la partie de la couche de nitrure de silicium 20 qui était disposée sous et autour de la région de silicium polycristallin éliminée. Cette gravure est réalisée en temps limité car on veut éliminer complètement la couche de nitrure 20 entre les espaceurs, sans éliminer complètement ces espaceurs qui, dans l'exemple d'application décrit, sont également en nitrure de silicium. Après quoi, on élimine la partie de la couche de silicium polycristallin 30 non soumise à implantation et il demeure en place comme l'illustre la figure 7C une portion de la couche de nitrure 20 sur toute la structure sauf au fond des zones étroites entre deux grilles. Ainsi, l'ouverture de contact vers la région de source/drain 11 commune à deux transistors adjacents est largement dégagée jusqu'à la limite entre les espaceurs 7.

Comme le représente la vue d'ensemble de la figure 6, on a obtenu grâce à l'invention des ouvertures dans la couche de nitrure de silicium 20, d'une part, en des emplacements 41 disposés en regard des ouvertures 23 ménagées dans le masque 22 comme cela est illustré en figure 3, d'autre part, en des emplacements 42 disposés entre deux transistors adjacents, c'est-à-dire entre deux superstructures en relief par rapport au reste du circuit intégré.

Selon un avantage de la présente invention, les ouvertures 42 occupent toute la largeur entre des espaceurs 7 en regard et le contact qui sera formé ensuite sera donc particulièrement efficace. On notera également que, pendant que l'on irradie la couche de silicium polycristallin, celle-ci est irradiée partout sauf aux emplacements situés entre deux superstructures en regard.

Après l'étape illustrée en figure 6, on pourra procéder à une métallisation de toute façon choisie. Par exemple, on pourra à nouveau recouvrir la structure d'une couche isolante planarisée, former un masque sur cette structure, y ouvrir des ouvertures relativement larges, graver de façon anisotrope la couche planarisée, et remplir ces ouvertures d'un métal pour former ainsi des vias relativement larges venant contacter les ouvertures 41 et 42.

On pourra aussi déposer directement une couche conductrice sur l'ensemble de la structure puis regraver cette couche conductrice pour la laisser en place seulement aux emplacements désirés, c'est-à-dire notamment au-dessus des ouvertures de contact 41 et 42. En ce cas, on remplit ensuite d'un matériau isolant les intervalles entre les zones laissées en place de la couche conductrice. Ceci est par exemple réalisé par un dépôt d'une couche d'un matériau isolant suivi d'une regravure physico-chimique.

Un avantage de la présente invention est que, pendant la formation des ouvertures 42, les parties supérieures des grilles sont bien protégées et que tout risque de court-circuit est évité.

Bien que la présente invention ait été décrite en relation avec une application particulière, on notera que, de façon générale, la présente invention prévoit un procédé de formation d'ouvertures de contact en divers emplacements de la surface supérieure d'un circuit intégré comportant des superstructures ou zones surélevées. Ces zones surélevées, comme cela a été décrit, peuvent correspondre à des grilles de transistors MOS ou, par exemple, à des empilements de grilles de points mémoire. Dans ce procédé, on vise d'une part à former des ouvertures en divers emplacements non critiques et, d'autre part, à former des ouvertures en des emplacements critiques entre deux superstructures (grille ou empilement de grilles). Pour cela, selon l'invention :
- on dépose une première couche de protection qui, dans le mode de réalisation décrit précédemment, est la couche de nitrure 20 mais qui pourrait être tout autre matériau présentant des propriétés d'isolement, de protection et de sélection de gravure appropriées,
- on forme des ouvertures aux emplacements non critiques dans cette première couche de protection,
- on revêt la structure d'une deuxième couche de protection qui, dans le mode de réalisation particulier décrit, est une couche de silicium polycristallin mais qui de façon générale peut être en tout matériau susceptible d'avoir des propriétés de gravure qui varient selon qu'il a été irradié ou non, et
- on procède à une implantation oblique tandis que la plaquette est entraînée en rotation de façon à implanter toute la surface supérieure de la structure sauf le fond des régions disposées entre deux superstructures et à pouvoir ainsi graver sélectivement le fond de ces régions critiques entre deux superstructures.

Bien entendu, la présente invention est susceptible de diverses variantes et modifications qui apparaîtront à l'homme de l'art. Notamment, les divers ordres de grandeur de dimensions ont été donnés uniquement à titre d'exemple. On comprendra que la présente invention vise à résoudre le problème de la création d'ouvertures critiques entre deux superstructures dans le cas où les tolérances d'alignement de masque risquent d'être inférieures à la distance entre une zone que l'on veut contacter et une région adjacente.

## Revendications

1. Procédé de formation d'ouvertures de contact en divers emplacements de la surface supérieure d'un circuit intégré comprenant des zones surélevées, certaines ouvertures dites ouvertures critiques (42) devant être formées entre deux zones surélevées voisines, **caractérisé en ce qu'**il comprend les étapes suivantes :
recouvrir l'ensemble de la structure d'une première couche de protection (20) ;
former des ouvertures non critiques (41) dans la première couche de protection ;
revêtir l'ensemble de la structure d'une seconde couche de protection (30) présentant la caractéristique de résister spécifiquement à une gravure dans les zones où elle n'a pas reçu d'irradiation ;
procéder à une irradiation oblique de sorte que la seconde couche de protection n'est pas irradiée au fond des régions situées entre deux zones surélevées ;
éliminer les parties non irradiées de la seconde couche de protection ;
éliminer les parties de la première couche de protection situées sous la seconde couche de protection aux emplacements où cette seconde couche de protection a été éliminée ; et
éliminer les parties irradiées de la seconde couche de protection.

2. Procédé selon la revendication 1, dans lequel la première couche de protection (20) est une couche de nitrure de silicium.

3. Procédé selon la revendication 1, dans lequel la seconde couche de protection (30) est une couche de silicium polycristallin.

4. Procédé selon la revendication 3, dans lequel l'irradiation est une implantation de bore.

5. Procédé selon la revendication 1, dans lequel l'irradiation oblique est réalisée sous un angle de 45 à 60°.

6. Procédé selon la revendication 1, dans lequel les zones surélevées correspondent à des zones de grille de transistors MOS.

7. Procédé selon la revendication 1, dans lequel les zones susceptibles d'être contactées sont revêtues d'un siliciure métallique.

8. Procédé selon la revendication 1, dans lequel l'étape de formation d'ouvertures non critiques (41) dans la première couche de protection comprend les étapes suivantes :
revêtir la structure d'une couche planarisée (21),
éliminer la couche planarisée aux emplacements desdites ouvertures non critiques,
graver lesdites ouvertures dans la première couche de protection, et
éliminer la couche planarisée (21).

9. Procédé selon la revendication 8, dans lequel ladite couche planarisée est une couche de résine.
